# EUROPEAN PATENT APPLICATION

(11) **EP 4 509 921 A1**
(43) Date of publication of application: **19.02.2025**
(21) Application number: 24191245.0
(22) Date of filing: 26.07.2024
(51) Int. Cl.: G03F 1/24, G03F 1/48, G03F 1/22

(54) **REFLECTIVE MASK BLANK AND MANUFACTURING METHOD OF REFLECTIVE MASK**

(30) Priority: 16.08.2023 JP 2023132455
(71) Applicant: Shin-Etsu Chemical Co., Ltd., Chiyoda-ku, Tokyo 1000005 (JP)
(72) Inventor: INAZUKI, Yukio, Joetsu-shi, 9428601 (JP); KOSAKA, Takuro, Joetsu-shi, 9428601 (JP); OGOSE, Taiga, Joetsu-shi, 9428601 (JP); SAKURAI, Keisuke, Joetsu-shi, 9428601 (JP); MIMURA, Shohei, Joetsu-shi, 9428601 (JP); KANEKO, Hideo, Joetsu-shi, 9428601 (JP)
(74) Representative: Mewburn Ellis LLP

(57) **Abstract**

As a reflective mask blank that includes a protection film containing ruthenium (Ru), a reflective mask blank in which the protection film is hard to be damaged and can be suppressed decrease of the thickness is provided by a reflective mask blank including a substrate, a multilayer reflection film, a protection film, an absorption film, and an etching prevention film that contains niobium (Nb) and is free of ruthenium (Ru) between the protection film and the absorption film.

## Description

### TECHNICAL FIELD

The present invention relates to a reflective mask blank which is a material for a reflective mask used in manufacturing semiconductor devices such as LSIs, and a method of manufacturing a reflective mask from the reflective mask blank.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form further fine patterns under continuous miniaturization of device patterns, an extreme ultraviolet lithography technique utilizing, as exposure light, extreme ultraviolet (here after refers to as "EUV") light having a shorter wavelength than the wavelength of ArF excimer laser light has been used. The EUV light has a wavelength of about 0.2 to 100 nm, in particular, is light having a wavelength of around 13.5 nm. The EUV light has a very low transparency to a substance and cannot be utilized for a conventional transmissive projection optical system or mask, thus, reflection type optical elemental devices are applied. Therefore, a reflective mask is also used as a mask for the pattern transfer.

In the reflective mask, a multilayer reflection film that reflects EUV light is formed on a substrate, and a pattern of an absorption film that absorbs EUV light is formed on the multilayer reflection film. On the other hand, a material (including also a material in which a resist layer is formed) before patterning the absorption film is called a reflective mask blank, and is used as a material for the reflective mask. The reflective mask blank commonly has a basic structure that includes a low thermal expansion substrate, a multilayer reflection film that is formed on either of the two main surfaces of the substrate and reflects EUV light, and an absorption film that is formed thereon and absorbs EUV light.

As the multilayer reflection film, a multilayer reflection film in which molybdenum (Mo) layers and silicon (Si) layers are alternately laminated to has a necessary reflectance for EUV light is commonly used. On the other hand, as the absorption film, tantalum (Ta) or others, which have a relatively large extinction coefficient with respect to EUV light, is used (Patent Document 1: JP-A 2002-246299).

Further, as a protection film (capping film) for protecting the multilayer reflection film in such as cleaning the reflective mask, a ruthenium (Ru) film, as disclosed in Patent Document 2: JP-A 2002-122981, is formed on the multilayer reflection film. In some cases, a hard mask film containing chromium (Cr) is formed on the absorption film as an etching mask in patterning the absorption film. On the other hand, a conducting film is formed on the other main surface of the substrate. As the conducting film, a metal nitride film has been proposed for electrostatic chucking, and a film containing manly chromium (Cr) or tantalum (Ta) is exemplified.

### Citation List

Patent Document 1: JP-A 2002-246299
Patent Document 2: JP-A 2002-122981

### SUMMARY OF THE INVENTION

The protection film requires a function for protecting the multilayer reflection film. In particular, examples of the functions include a function for protecting the multilayer reflection film so as not to be exposed to an etching gas or a cleaning liquid in patterning process of the absorption film, and a function for suppressing reduction of reflectance caused by repeated exposures in exposure using the reflective mask.

In process of manufacturing a reflective mask with using a reflective mask blank as a material, to control pattern shape, a certain amount of over etching is generally performed in forming a pattern to the absorption film by dry etching. The protection film is exposed to the etching and is damaged by performing the over-etching. In the case that the absorption film is composed of a material containing tantalum (Ta), since a gas containing chlorine (Cl) and being free of oxygen (O) is preferably used as an etching gas, the protection film is required to be resistant to dry etching using the gas containing chlorine (Cl) and being free of oxygen (O).

Further, in the case that a pattern of a hard mask film that is obtained by patterning the hard mask film made of a material containing chromium (Cr) is used as an etching mask in forming a pattern to the absorption film, the pattern of the hard mask film is generally removed by dry etching using a gas containing chlorine (Cl) and oxygen (O) after forming a pattern of the absorption film. At this time, the protection film is also exposed to the dry etching using a gas containing chlorine (Cl) and oxygen (O). Therefore, the protection film is required to be resistant to the dry etching using a gas containing chlorine (Cl) and oxygen (O).

Moreover, cleaning using sulfuric acid-hydrogen peroxide mixture (SPM) is performed to remove residues of a resist which is used in manufacturing the reflective mask, or to remove contaminations caused by repeated uses of the reflective mask. Therefore, the protection film is also required to be resistant to the sulfuric acid-hydrogen peroxide mixture (SPM).

During dry etching in manufacturing of the reflective mask, if the protection film is damaged and film quality and film thickness are changed, problems such as loss of the function for protecting the multilayer reflection film are caused. For this reason, it has been proposed to add an additive element such as niobium (Nb) to a protection film containing ruthenium (Ru) to improve the resistance to dry etching and to enhance the function of the protection film for protecting the multilayer reflection film.

However, even if the protection film containing ruthenium (Ru) is enhanced in the resistance to the dry etching by adding the additive element such as niobium (Nb), in the dry etching of the protection film composed of a material containing tantalum (Ta), the protection film is thinned when the protection film is exposed to the gas containing chlorine (Cl) and being free of oxygen (O). Further, in the removal of the pattern of the hard mask film, the protection film is also thinned when the protection film is exposed to the gas containing chlorine (Cl) and oxygen (O). Moreover, the protection film is also thinned in the cleaning using the sulfuric acid-hydrogen peroxide mixture (SPM).

Accordingly, chemical damage to the protection film is unavoidable, and the protection film is thinned also by physical damage, thus, it is necessary to suppress the deterioration of the functions of the protective film for protecting the multilayer reflection film due to decrease of thickness.

A tantalum (Ta)-based films are generally used for the absorption film. However, it is required that the pattern high which corresponds to film thickness of the absorption film is lowered to improve accuracy in pattern transfer to a wafer, thus, attention has been focused on chromium (Cr)-based absorption films, which can be thinned compared with the tantalum (Ta)-based absorption films.

However, when the chromium (Cr)-based absorption film is formed on a ruthenium (Ru)-based protection film that generally used for the protection film for the multilayer reflection film, the ruthenium (Ru)-based film is also etched by dry etching using a gas containing chlorine (Cl) and oxygen (O) that is used for dry etching of the chromium (Cr)-based film, and the ruthenium (Ru)-based protection film is damaged and thinned.

The present invention has been made to solve the above problems, and an object of the present invention is to provide a reflective mask blank including a protection film that is hard to be damaged and can be suppressed decrease of the thickness, when an absorption film that is formed on the protection film composed of a material containing ruthenium (Ru) is etched by dry etching using a gas containing chlorine (Cl) and oxygen (O), and to provide a manufacturing method of a reflective mask with using the reflective mask blank.

The inventors have made earnestly studies to solve the above problems. As a result, the inventors found that, in a reflective mask blank in which an absorption film is formed on a protection film containing ruthenium (Ru), the problems can be solved by disposing an etching prevention film that contains niobium (Nb) and is free of ruthenium (Ru) between the protection film and the absorption film.

In one aspect, the invention provides a reflective mask blank which is a material for a reflective mask used in EUV lithography utilizing EUV light as exposure light, including
a substrate,
a multilayer reflection film that is formed on one main surface of the substrate, and reflects the exposure light,
a protection film for protecting the multilayer reflection film that is formed on the multilayer reflection film, and
an absorption film that is formed on the protection film, and absorbs the exposure light, wherein
the protection film contains ruthenium (Ru), and
the reflective mask blank further includes an etching prevention film that contains niobium (Nb) and is free of ruthenium (Ru) between the protection film and the absorption film.

Preferably, the etching prevention film consists of simple niobium (Nb), or a niobium (Nb) compound containing niobium (Nb) and oxygen (O).

Preferably, the protection film consists of ruthenium (Ru).

Preferably, the absorption film contains chromium (Cr).

Preferably, the absorption film contains tantalum (Ta), and the reflective mask blank further includes an etching mask film containing chromium (Cr) on the absorption film.

In another aspect, the invention provides a manufacturing method of a reflective mask, including the step of:
pattering the absorption film of the reflective mask blank by dry etching using a gas containing chlorine (Cl) and oxygen (O); or
after patterning the absorption film of the reflective mask blank, removing the etching mask film by dry etching using a gas containing chlorine (Cl) and oxygen (O).

In the other aspect, the invention provides a manufacturing method of a reflective mask from the reflective mask blank, including the step of:
after forming a pattern of the absorption film, removing the etching prevention film at the portion exposed by removing the absorption film.

Preferably, the etching prevention film at the portion exposed by removing the absorption film is removed by sulfuric acid-hydrogen peroxide mixture (SPM).

### ADVANTAGEOUS EFFECTS

According to the invention, a reflective mask blank including a protection film that is hard to be damaged and can be suppressed decrease of the thickness, when an absorption film that is formed on the protection film composed of a material containing ruthenium (Ru) is etched by dry etching using a gas containing chlorine (Cl) and oxygen (O) can be provided.

### BRIEF DESCRIPTION OF THE DRAWINGS

FIG. 1 is a cross-sectional view illustrating an example (first embodiment) of a reflective mask blank of the invention.
FIG. 2 is a cross-sectional view illustrating an example (second embodiment) of a reflective mask blank of the invention.
FIG. 3 is a cross-sectional view illustrating an example of a reflective mask of the invention.

### FURTHER EXPLANATIONS; OPTIONS AND PREFERENCES

A reflective mask blank of the invention includes a substrate, a multilayer reflection film that is formed on one main surface (front surface) of the substrate, and reflects exposure light, a protection film that is formed on the multilayer reflection film, and an absorption film that is formed on the protection film, and absorbs the exposure light. Further, the reflective mask blank of the invention includes an etching prevention film between the protection film and the absorption film.

The reflective mask blank of the invention is suitable for a material for a reflective mask used in EUV lithography utilizing EUV light as exposure light. A wavelength of EUV light used in EUV lithography utilizing EUV light as exposure light is 13 to 14 nm, commonly about 13.5 nm. A reflective mask blank and a reflective mask using EUV light as exposure light are also called an EUV mask blank and an EUV mask, respectively.

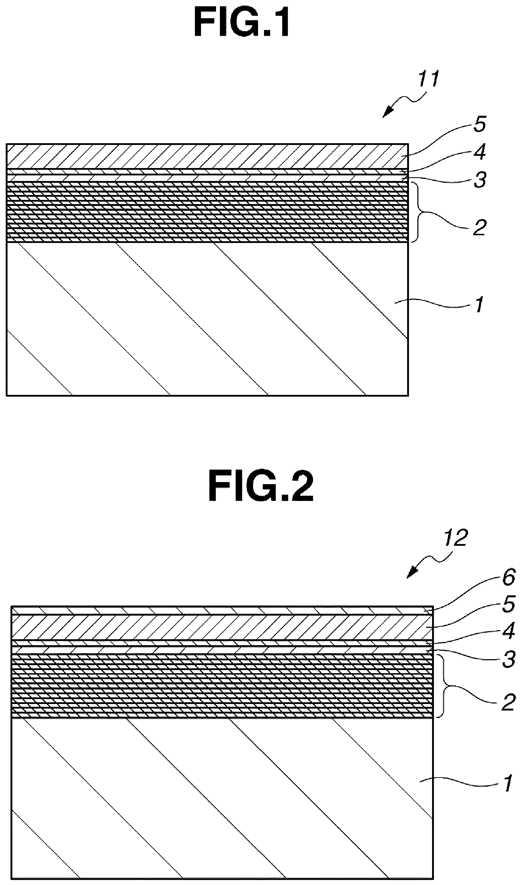

FIG. 1 is a cross-sectional view illustrating an example (first embodiment) of a reflective mask blank of the invention. This reflective mask blank 11 includes a substrate 1, and on the substrate 1, a multilayer reflection film 2 that is formed in contact with the substrate 1, a protection film 3 that is formed in contact with the multilayer reflection film 2, an etching prevention film 4 that is formed in contact with the protection film 3, and an absorption film 5 that is formed in contact with the etching prevention film 4.

For use in EUV light exposure, the substrate preferably has low thermal expansion property. For example, the substrate is preferably composed of a material having a coefficient of thermal expansion within ±2×10⁻⁸/°C, preferably within ±5×10⁻⁹/°C. As such a material, a titania-doped quartz glass (SiO₂-TiO₂-based glass) is exemplified. Further, a substrate having a sufficiently flattened surface is preferably used. The main surface of the substrate has a surface roughness, as an RMS value, of preferably not more than 0.5 nm, more preferably not more than 0.2 nm. Such a surface roughness can be obtained by polishing of the substrate, or others. The substrate preferably has dimensions of 152 mm-square in the main surface and 6.35 mm in thickness. A substrate having the dimensions is so-called a 6025 substrate, which has dimensions of 6 inches-square in the main surface and 0.25 inches in thickness.

The multilayer reflection film is a film that reflects exposure light, in the reflective mask. The multilayer reflection film is preferably formed in contact with one main surface of the substrate, however, may be formed via another film such as an underlayer film on the one main surface of the substrate. The multilayer reflection film has a periodically laminated structure in which high refractive index layers having a comparatively high refractive index with respect to exposure light and low refractive index layers having a comparatively low refractive index with respect to the exposure light are alternately laminated.

The high refractive index layer is preferably composed of a material containing silicon (Si). The high refractive index layer may contain at least one additive element selected from the group consisting of oxygen (O), nitrogen (N), carbon (C), boron (B) and hydrogen (H). Further, the high refractive index layer may be configured by a multilayer including a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm.

The low refractive index layer is preferably composed of a material containing molybdenum (Mo). The low refractive index layer may be composed of a material containing ruthenium (Ru). The low refractive index layer may contain at least one additive element selected from the group consisting of oxygen (O), nitrogen (N), carbon (C), boron (B) and hydrogen (H). Further, the low refractive index layer may be configured by a multilayer including a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm.

The periodically laminated structure may include the high refractive index layer and the low refractive index layer, and may include at least one high refractive index layer and at least one low refractive index layer in one cycle. The one cycle includes at least two layers and may be configured by, for example, one high refractive index layer and one low refractive index layer. Further, the one cycle may include at least two high refractive index layers that have different compositions (for example, different ratios in composition, or different compositions with or without an additive element) each other, and may include at least two low refractive index layers that have different compositions (for example, different ratios in composition, or different compositions with or without an additive element) each other. In this case, the one cycle includes at least three layers and may include four or five or more layers, however, preferably not more than eight layers. The periodically laminated structure has the cycles of preferably not less than 30 cycles, and preferably not more than 50 cycles, more preferably not more than 40 cycles. In the case that the low refractive index layer is composed of a material containing ruthenium (Ru), the layer remotest from the substrate (uppermost layer) in the periodically laminated structure is preferably the high refractive index layer.

A thickness of the multilayer reflection film having the periodically laminated structure is adjusted according to an exposure wavelength and an incident angle of the exposure light, and has a thickness of preferably not less than 200 nm, more preferably not less than 270 nm, and preferably not more than 400 nm, more preferably not more than 290 nm.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon caused by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets can be attached. In particular, the multilayer reflection film may be formed with using, as targets, targets appropriately selected from the group consisting of a molybdenum (Mo) target for forming a molybdenum (Mo)-containing layer, a ruthenium (Ru) target for forming a ruthenium (Ru)-containing layer, a silicon (Si) target for forming a silicon (Si)-containing layer, and other targets, and with using, as a sputtering gas, a rare gas such as helium (He) gas, argon (Ar) gas, krypton (Kr) gas and xenon (Xe) gas.

Further, in the case that the sputtering is reactive sputtering using a reactive gas, for example, a nitrogen-containing gas such as nitrogen (N₂) gas to form a nitrogen (N)-containing film, an oxygen-containing gas such as oxygen (O₂) gas to form an oxygen (O)-containing film, a nitrogen oxide gas such as nitrous oxide (N₂O) gas, nitrogen monoxide (NO) gas and nitrogen dioxide (NO₂) gas to form a nitrogen (N) and oxygen (O)-containing film, a carbon oxide gas such as carbon monoxide (CO) gas and carbon dioxide (CO₂) gas to form a carbon (C) and oxygen (O)-containing film, a hydrogen-containing gas such as hydrogen (H₂) gas to form a hydrogen (H)-containing film, or a hydrocarbon gas such as methane (CH₄) gas to form a carbon (C) and hydrogen (H)-containing film may be used with the rare gas.

Moreover, a molybdenum (Mo) target added with boron (B) (a molybdenum boride (MoB) target), or a silicon (Si) target added with boron (B) (a silicon boride (SiB) target) may be used to form a boron (B)-containing layer.

The protection film is also called a capping film. The protection film is a film for protecting the multilayer reflection film. The protection film is generally formed in contact with the multilayer reflection film. The protection film is composed of a material containing ruthenium (Ru).

Examples of the materials containing ruthenium (Ru) include simple substance of ruthenium (Ru), and an alloy consisting of ruthenium (Ru) and other metal or metalloid different from ruthenium (Ru). Examples of the other metals or metalloids different from ruthenium (Ru) include niobium (Nb), rhenium (Re), zirconium (Zr), titanium (Ti), chromium (Cr), silicon (Si) and others. Among the materials containing ruthenium (Ru), simple substance of ruthenium (Ru) is particularly preferred, and the protection film preferably consists of ruthenium (Ru). A content of the other metal or metalloid different from ruthenium (Ru) in the protection film is preferably not more than 30 at%, more preferably not more than 20 at% on average for the whole of the film. A lower limit of the content of the other metal or metalloid different from ruthenium (Ru) in the protection film is preferably not less than 5 at%, more preferably not less than 10 at% on average for the whole of the film, however, not limited particular thereto.

The protection film may have a single layer structure or a multilayer structure combining multiple layers having different compositions. Further, each layer constituting the single layer or the multiple layers may have a compositional graded structure in which composition continuously varies along the thickness direction. Particularly, in the protection film, either or both of the side close to the multilayer reflection film (the layer close to the multilayer reflection film in the case of the multilayer structure), and the side remotest from the multilayer reflection film (the layer remotest from the multilayer reflection film in the case of the multilayer structure) may consist of ruthenium (Ru).

In the case that the protection film has a multilayer structure or a compositional graded structure, the other metal or metalloid different from ruthenium (Ru) preferably has a content that increases from the multilayer reflection film side to the side remote from the multilayer reflection film in a part of or the whole of the protection film in the thickness direction. Particularly, in the case that niobium (Nb) is contained as the other metal or metalloid different from ruthenium (Ru), niobium (Nb) is effective to improve resistance to dry etching using a gas containing chlorine (Cl) and oxygen (O). Therefore, niobium (Nb) preferably has a content that increases from the multilayer reflection film side to the side remote from the multilayer reflection film in a part of or the whole of the protection film in the thickness direction.

As the dry etching using a gas containing chlorine (Cl) and oxygen (O), in particular, dry etching using a gas containing chlorine (Cl₂) gas and oxygen (O₂) gas is exemplified in the invention. The gas containing chlorine (Cl) and oxygen (O) may contain a rare gas such as helium (He) gas, argon (Ar) gas, krypton (Kr) gas and xenon (Xe) gas.

The protection film has a thickness of preferably not less than 2 nm, more preferably not less than 3 nm, and preferably not more than 5 nm, more preferably not more than 4 nm.

The protection film can be formed by sputtering using, as a target, an appropriate target selected from the group consisting of a ruthenium (Ru) target, a target of the other metal or metalloid different from ruthenium (Ru), in particular, a niobium (Nb) target, a rhenium (Re) target, a zirconium (Zr) target, a titanium (Ti) target, a chromium (Cr) target, a silicon (Si) target, a target in which two or more selected from the group consisting of niobium (Nb), rhenium (Re), zirconium (Zr), titanium (Ti), chromium (Cr) and silicon (Si) are mixed, and a target in which ruthenium (Ru) is mixed with at least one other metal or metalloid different from ruthenium (Ru) selected from the group consisting of niobium (Nb), rhenium (Re), zirconium (Zr), titanium (Ti), chromium (Cr) and silicon (Si), and using, as a puttering gas, a rare gas such as helium (He) gas, argon (Ar) gas, krypton (Kr) gas and xenon (Xe) gas. The sputtering is preferably performed by a magnetron sputtering method.

In the reflective mask, the absorption film is a film that absorbs exposure light and reduces reflectance. In the reflective mask, a transfer pattern is formed by a difference in reflectance between a portion where an absorption film is formed and a portion where an absorption film is not formed. The absorption film may consist of a single layer or multiple layers, and an antireflection layer may be formed on the surface of the absorption film.

The absorption film preferably contains tantalum (Ta) or chromium (Cr). The absorption film is a film that can absorb EUV light and is composed of a material processable to a pattern. The absorption film is preferably composed of a material containing tantalum (Ta) or chromium (Cr).

The material containing tantalum (Ta) may contain oxygen (O), nitrogen (N), carbon (C), boron (B) or other elements. Examples of the materials containing tantalum (Ta) include simple substance of Ta, and a tantalum (Ta) compound such as TaO, TaN, TaON, TaC, TaCO, TaCN, TaCON, TaB, TaOB, TaNB, TaONB, TaCB, TaCOB, TaCNB and TaCONB. In addition, the description of the chemical formula of a metal or metalloid compound indicates the constituent elements of the compound, and does not mean their composition ratio. (The same applies below.)

In case that the material containing tantalum (Ta) is free of oxygen (O), the material containing tantalum (Ta) can be etched by dry etching using a gas containing chlorine (Cl). In this case, when the material containing tantalum (Ta) contains nitrogen (N), an etching rate in the dry etching using a gas containing chlorine (Cl) increases. Further, when the material containing tantalum (Ta) contains nitrogen (N), and is free of oxygen (O), an etching selectivity to the etching prevention film in the dry etching using a gas containing chlorine (Cl) increases. Therefore, in the absorption film containing tantalum (Ta), the portion that contacts with the etching prevention film is preferably free of oxygen (O), and preferably contain a large amount of nitrogen (N).

As the dry etching using a gas containing chlorine (Cl), in particular, dry etching using a gas containing chlorine (Cl₂) gas, hydrogen chloride (HCl) gas or others is exemplified in the invention. The gas containing chlorine (Cl) is preferably free of a gas containing oxygen (O). The gas containing chlorine (Cl) may contain a rare gas such as helium (He) gas, argon (Ar) gas, krypton (Kr) gas and xenon (Xe) gas.

The material containing chromium (Cr) may contain oxygen (O), nitrogen (N), carbon (C) or other elements. Examples of the materials containing chromium (Cr) include simple substance of Cr, and a chromium (Cr) compound such as CrO, CrN, CrON, CrC, CrCO, CrCN, and CrCON.

The absorption film has a sheet resistance of preferably not more than 1×10⁶ Ω/square, more preferably not more than 1 × 10⁵ Ω/square. The absorption film has a surface roughness Sq of preferably not more than 0.8 nm, more preferably not more than 0.6 nm.

The absorption film (each layer constituting the absorption film) can be formed by sputtering, and the sputtering is preferably performed by a magnetron sputtering method. In particular, the absorption film may be formed by sputtering using an appropriate target selected, according to the composition, from the group consisting of a tantalum (Ta) target, and a tantalum (Ta) compound target (a target containing tantalum (Ta), and oxygen (O), nitrogen (N), carbon (C), boron (B) or other elements) in the case of forming by the material containing tantalum (Ta), or from the group consisting of a chromium (Cr) target, and a chromium (Cr) compound target (a target containing chromium (Cr), and oxygen (O), nitrogen (N), carbon (C) or other elements) in the case of forming by the material containing chromium (Cr), and using, as a sputtering gas, a rare gas such as helium (He) gas, neon (Ne) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, and a carbon oxide (CO, CO₂) gas, with the rare gas.

An etching mask film having different etching characteristics from that of the absorption film can be provided, as a hard mask for the absorption film, on the absorption film at the side remote from the substrate. The etching mask film acts as a hard mask in dry etching of the absorption film. The etching mask film is preferably formed in contact with the absorption film. The etching mask film may consist of a single layer or multiple layers.

FIG. 2 is a cross-sectional view illustrating an example (second embodiment) of a reflective mask blank of the invention. This reflective mask blank 12 includes a substrate 1, and on the substrate 1, a multilayer reflection film 2 that is formed in contact with the substrate 1, a protection film 3 that is formed in contact with the multilayer reflection film 2, an etching prevention film 4 that is formed in contact with the protection film 3, an absorption film 5 that is formed in contact with the etching prevention film 4, and an etching mask film 6 that is formed in contact with the absorption film 5.

In the case that the absorption film contains tantalum (Ta), the etching mask film preferably contains chromium (Cr), and the etching mask film is preferably composed of a material containing chromium (Cr). The material containing chromium (Cr) has different etching characteristics from the absorption film in processing the absorption film composed of a material containing tantalum (Ta). The etching mask film composed of the material containing chromium (Cr) acts as an etching mask in dry etching of the absorption film composed of a material containing tantalum (Ta), and is suitable. Therefore, the material containing chromium (Cr) for the etching mask film is preferably free of tantalum (Ta). Examples of the materials containing chromium (Cr) include simple substance of Cr, CrO, CrN, CrON, CrC, CrOC, CrNC, and CrONC.

In the case that the absorption film contains chromium (Cr), the etching mask film preferably contains tantalum (Ta), and the etching mask film is preferably composed of a material containing tantalum (Ta). The material containing tantalum (Ta) has different etching characteristics from the absorption film in processing the absorption film composed of a material containing chromium (Cr). The etching mask film composed of the material containing tantalum (Ta) acts as an etching mask in dry etching of the absorption film composed of a material containing chromium (Cr), and is suitable. Therefore, the material containing tantalum (Ta) for the etching mask film is preferably free of chromium (Cr). Examples of the materials containing tantalum (Ta) include simple substance of Ta, TaO, TaN, TaON, TaC, TaOC, TaNC, and TaONC. The material containing tantalum (Ta) may further contain boron (B) or hydrogen (H).

After the pattern of the absorption film is formed, the etching mask film may be remained in the reflective mask, for example, as a reflectance reducing film for reducing reflectance at a wavelength of light used in inspection such as pattern inspection, or may be removed to be absent on the reflective mask.

When the hard mask film is too thin, the hard mask film may not act as an etching mask, and when the hard mask film is too thick, processing properties may be deteriorated. Thus, the hard mask film has a thickness of preferably not less than 1 nm, more preferably not less than 2 nm, even more preferably not less than 5 nm, and preferably not more than 20 nm, more preferably not more than 10 nm, however, not limited particular thereto.

The etching mask film can be formed by sputtering. In particular, the etching mask film may be formed by sputtering using an appropriate target selected, according to the composition, from the group consisting of a chromium (Cr) target, and a chromium (Cr) compound target (a target containing chromium (Cr), and oxygen (O), nitrogen (N), carbon (C) or other elements) in the case of forming by the material containing chromium (Cr), or from the group consisting of a tantalum (Ta) target, and a tantalum (Ta) compound target (a target containing tantalum (Ta), and oxygen (O), nitrogen (N), carbon (C), boron (B) or other elements) in the case of forming by the material containing tantalum (Ta), and using, as a sputtering gas, a rare gas such as helium (He) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, a carbon oxide (CO, CO₂) gas, hydrogen (H₂) gas, and a hydrogen carbon gas (for example, methane (CH₄) gas), with the rare gas. The sputtering is preferably performed by a magnetron sputtering method.

The etching prevention film is a film for protecting the protection film and preventing etching to the protection film in dry etching using a gas containing chlorine (Cl) and oxygen (O). Thus, the etching prevention film acts as an etching stopper to the dry etching using a gas containing chlorine (Cl) and oxygen (O). The etching prevention film is a film containing niobium (Nb) and is free of ruthenium (Ru).

A film containing niobium (Nb) is resistant to dry etching using a gas containing chlorine (Cl) and oxygen (O), which is used for etching of a chromium (Cr)-based film, and acts as a film for protecting the protection film. Thus, the etching prevention film containing niobium (Nb) can prevent damage of the protection film in patterning the absorption film containing chromium (Cr) by dry etching using a gas containing chlorine (Cl) and oxygen (O), or in removing the etching mask film containing chromium (Cr) by dry etching using a gas containing chlorine (Cl) and oxygen (O) after patterning the absorption film containing tantalum (Ta) with using a pattern of the etching mask film containing chromium (Cr).

The etching prevention film preferably consists of simple substance of niobium (Nb), however, may be composed of a niobium (Nb) compound containing niobium (Nb) and oxygen (O), for example, niobium oxide (NbO). The niobium (Nb) compound containing niobium (Nb) and oxygen (O) preferably contains niobium (Nb) and oxygen (O) as main components, and has a total content of niobium (Nb) and oxygen (O), on average of the whole film, of preferably not less than 70 at%, more preferably not less than 80 at%, even more preferably 91 at%, further preferably 100 at%. Further, the niobium (Nb) compound containing niobium (Nb) and oxygen (O) preferably has a content of niobium (Nb), on average of the whole film, of preferably not less than 20 at%, more preferably not less than 28 at%, even more preferably not less than 29 at%.

The niobium (Nb) compound containing oxygen (O) may further contain an element or a compound that can be etched by dry etching using a gas containing chlorine (Cl) or a gas containing fluorine (F), and may contains, for example, an element such as silicon (Si), nitrogen (N), carbon (C) and other elements, or a compound of the element. A content of the element other than niobium (Nb) and oxygen (O) is preferably not more than 30 at%, more preferably not more than 20 at%, on average of the whole film. In this case, a total content of oxygen (O), nitrogen (N) and carbon (C) is preferably not more than 72 at%, on average of the whole film.

The etching prevention film may consist of a single layer or multiple layers. Examples of multiple layers includes a combination of layers containing niobium (Nb) that have different compositions or composition ratios such as a combination of a layer composed of a niobium (Nb) compound containing oxygen (O) and a layer composed of niobium (Nb), and a combination of layers composed of a niobium (Nb) compound containing oxygen (O) that have different composition ratios. Each layer may be a single composition layer or a compositionally graded layer having graded composition. When the etching prevention film contains oxygen (O), it is preferable that the oxygen (O) content at the surface side (the side remote from the substrate) is high; or the layer at the surface side is the layer composed of a niobium (Nb) compound containing oxygen (O), and the layer at the substrate side is the layer composed of niobium (Nb) or a layer containing niobium (Nb) and being free of oxygen (O).

As the dry etching using a gas containing fluorine (F), in particular, dry etching using a gas containing carbon tetrafluoride (CF₄) gas or sulfur hexafluoride (SF₆) gas is exemplified in the invention. The gas containing fluorine (F) may contain a rare gas such as helium (He) gas, argon (Ar) gas, krypton (Kr) gas and xenon (Xe) gas.

The etching prevention film has a thickness of preferably not less than 0.5 nm, more preferably not less than 1 nm, and preferably not more than 10 nm, more preferably not more than 5 nm.

The etching prevention film can be formed by sputtering. The etching prevention film may be formed by sputtering using, as a target, a niobium (Nb) target and an optional target of metal or metalloid other than niobium (Nb), in particular, a silicon (Si) target or other targets, and using, as a sputtering gas, a rare gas such as helium (He) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, and a carbon oxide (CO, CO₂) gas, with the rare gas. The sputtering is preferably performed by a magnetron sputtering method.

In the case that the etching prevention film contains oxygen (O), niobium (Nb) is susceptible to natural oxidation, thus, the etching prevention film composed of a niobium (Nb) compound containing oxygen (O) can be formed by forming a simple niobium (Nb) film and exposing it to an atmosphere containing oxygen (O) such as the air to oxidize. To oxidize the simple niobium (Nb), the film may be heat-treated.

A conductive film (conducting film) used for electrostatic chucking a reflective mask to an exposure apparatus (for example, an EUV scanner) may be formed on the other main surface (back-side surface) which is the surface opposite to the one main surface in the substrate, preferably in contact with the other main surface.

The conducting film preferably has a sheet resistance of not more than 100 Ω/square, and a material for the conducting film is not limited particularly. Examples of materials of the conducting film include, for example, a material containing tantalum (Ta) or chromium (Cr). The material containing tantalum (Ta) may contain oxygen (O), nitrogen (N), carbon (C), boron (B) or other elements, and the material containing chromium (Cr) may contain oxygen (O), nitrogen (N), carbon (C) or other elements. Examples of the materials containing tantalum (Ta) include, for example, simple substance of Ta, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include, for example, simple substance of Cr, and a chromium (Cr) compound such as CrO, CrN, CrON, CrC, CrCN, CrCO, CrCON.

The conducting film has a thickness of normally about 20 to 300 nm, however, not limited particularly thereto as long as the thickness is enough to act for electrostatic chucking use. The conducting film is preferably formed so as to have a thickness at which film stresses between the conducting film, and the film(s) and pattern(s) of the film(s) formed at the one main surface (front surface) side are balanced after obtaining the reflective mask, i.e., after forming the pattern of the absorption film. The conducting film may be formed before forming the multilayer reflection film, or after forming all the films on the substrate at the multilayer reflection film side. After forming a part of the films on the substrate at the multilayer reflection film side, the conducting film may be formed, and then the remainder of the films at the multilayer reflection film side may be formed on the substrate. The conducting film can be formed by, for example, a magnetron sputtering method.

The reflective mask blank may include a resist film formed on the side remotest from the substrate. The resist film is preferably an electron beam (EB) resist.

From the reflective mask blank, for example, a reflective mask including a substrate, a multilayer reflection film that is formed on one main surface of the substrate, a protection film that is formed in contact with the multilayer reflection film, a pattern of an etching prevention film that is formed in contact with the protection film, and a pattern of an absorption film (an absorption film pattern) that is formed in contact with the pattern of the etching prevention film. In a reflective mask, a transfer pattern is formed by a difference in reflectance between a portion where an absorption film is formed and a portion where an absorption film is not formed.

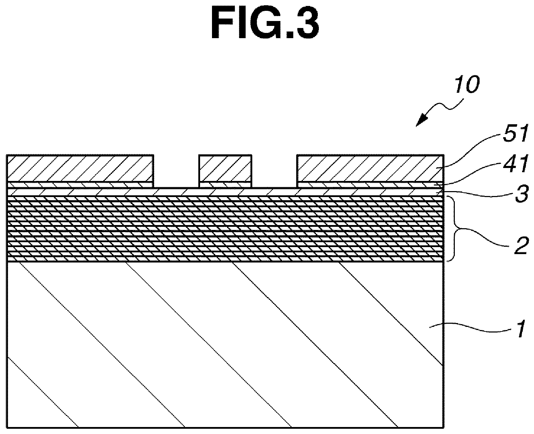

FIG. 3 is a cross-sectional view illustrating an example of a reflective mask of the invention. This reflective mask 10 includes a substrate 1, and on the substrate 1, a multilayer reflection film 2 that is formed in contact with the substrate 1, a protection film 3 that is formed in contact with the multilayer reflection film 2, a pattern of an etching prevention film 41 that is formed in contact with the protection film 3, and a pattern of an absorption film 51 that is formed in contact with the pattern of the etching prevention film 41. In this case of the reflective mask 10, the pattern of the absorption film 51 is formed via the pattern of the etching prevention film 41 on the protection film 3.

A reflective mask of the invention may be manufactured by the method including the steps of:
preparing the reflective mask blank,
optionally forming a resist film on the absorption film,
forming a resist pattern from the resist film on the absorption film,
forming a pattern of the absorption film by etching the absorption film with using the resist pattern as an etching mask,
removing the resist pattern, and
removing the etching prevention film at the portion exposed by removing the absorption film.

The absorption film composed of a material containing chromium (Cr) can be etched by dry etching using a gas containing chlorine (Cl) and oxygen (O).

In this case, the etching prevention film containing niobium (Nb) is not etched by the dry etching using a gas containing chlorine (Cl) and oxygen (O). Thus, damages to the protection film can be prevented.

The absorption film composed of a material containing tantalum (Ta) can be etched by dry etching using a gas containing chlorine (Cl) or a gas containing fluorine (F).

In the dry etching of the absorption film composed of a material containing tantalum (Ta), dry etching using a gas containing fluorine (F) is suitable for etching of a portion containing oxygen (O) formed by natural oxidation or others, and dry etching using a gas containing chlorine (Cl) is suitable for etching of a portion not containing oxygen (O). Therefore, it is preferable to pattern the absorption film containing tantalum (Ta) by initially performing dry etching using a gas containing fluorine (F), and then switching to dry etching using a gas containing chlorine (Cl) along the way. In this case, since the etching prevention film has low resistance to dry etching using a gas containing chlorine (Cl), it is preferable to perform the etching so that the etching prevention film is not disappeared. To perform the etching so that the etching stopper film is not disappeared, for example, an end point detector attached to an etching apparatus may be utilized.

Further, a reflective mask of the invention may be manufactured by the method including the steps of:
preparing the reflective mask blank,
optionally forming a resist film on the etching mask film,
forming a resist pattern from the resist film on the etching mask film,
forming a pattern of the etching mask film by etching the etching mask film with using the resist pattern as an etching mask,
forming a pattern of the absorption film by etching the absorption film with using the pattern of the etching mask film as an etching mask,
removing the resist pattern,
removing the pattern of the etching mask film, and
removing the etching prevention film at the portion exposed by removing the absorption film.

After forming the pattern of the absorption film, in the case that the etching mask film is a film composed of a material containing tantalum (Ta), the pattern of the etching mask film can be removed by dry etching using a gas containing chlorine (Cl) or a gas containing fluorine (F). In the case that the etching mask film is a film composed of a material containing chromium (Cr), the pattern of the etching mask film can be removed by dry etching using a gas containing chlorine (Cl) and oxygen (O).

In the case that the absorption film contains tantalum (Ta), a film containing chromium (Cr) is applied to the etching mask film, and the etching mask film may be patterned to form the pattern of the etching mask film by dry etching using a gas containing chlorine (Cl) and oxygen (O). The etching mask film after patterning the absorption film with using the pattern of the etching mask film as an etching mask may be removed by dry etching using a gas containing chlorine (Cl) and oxygen (O).

In this case, the etching prevention film containing niobium (Nb) is not etched by dry etching using a gas containing chlorine (Cl) and oxygen (O). Thus, damages to the protection film can be prevented.

The resist pattern and the etching prevention film at the portion exposed by removing the absorption film can be removed by sulfuric acid-hydrogen peroxide mixture (SPM).

Further, the etching prevention film at the portion exposed by removing the absorption film can be removed by dry etching using a gas containing chlorine (Cl) or a gas containing fluorine (F). However, when niobium (Nb) is exposed to a gas containing oxygen (O), niobium (Nb) is oxidized to form niobium oxide (NbO). Niobium oxide (NbO) is hard to remove by dry etching using a gas containing chlorine (Cl) or a gas containing fluorine (F), thus, the etching prevention film is preferably removed by sulfuric acid-hydrogen peroxide mixture (SPM). In this case, the etching prevention film may be removed simultaneously with removing the resist pattern.

The pattern of the absorption film and the exposed protection film may be provided to treatment of contacting with sulfuric acid-hydrogen peroxide mixture (SPM), for example, cleaning by sulfuric acid-hydrogen peroxide mixture (SPM).

### EXAMPLES

Examples of the invention are given below by way of illustration and not by way of limitation.

### Examples 1 and 2

On one main surface of a precision-polished low thermal expansion substrate made of titania-doped SiO₂, a multilayer reflection film in which a molybdenum (Mo) layer having a thickness of 3 nm and a silicon (Si) layer having a thickness of 4 nm, as one pair (cycle), were alternately laminated for 40 pairs (cycles) was formed by sputtering. Next, a ruthenium (Ru) film having a thickness of 3 nm, as a protection film, was formed on the multilayer reflection film by sputtering. The multilayer reflection film and the protection film had a reflectance of 64% at an incident angle of 6° with respect to EUV light having a wavelength of 13.5 nm.

Next, a niobium oxide (NbO) film (Nb:O=2:5 (atomic ratio)) having a thickness of 2 nm, as an etching prevention film, was formed on the protection film. The niobium (NbO) film was formed firstly by sputtering with applying a power of 750W to a niobium (Nb) target while feeding argon (Ar) gas at 12 SCCM to form a niobium (Nb) film, then oxidizing the niobium (Nb) film by heat treatment in the air at 150 °C for 10 minutes.

Next, a chromium nitride (CrN) film (Cr:N=4:1 (atomic ratio)) having a thickness of 45 nm, as an absorption film, was formed on the etching prevention film. The chromium nitride (CrN) film was formed by sputtering with applying a power of 1000W to a chromium (Cr) target while feeding argon (Ar) gas at 20 SCCM and nitrogen (N₂) gas at 10 SCCM.

Further, on the other main surface of the substrate, a tantalum nitride (TaN) film having a thickness of 70 nm, as a conducting film, was formed by sputtering to obtain a reflective mask blank.

A reflective mask was manufactured from the obtained reflective mask blank. First, a resist film was formed on the absorption film by coating an electron beam (EB) resist, and a resist pattern that includes line-and-space (L/S) patterns having a line width of 200 nm was formed by drawing patterns with using electron (EB) beam, and developing.

Next, the absorption film was patterned by dry etching using a gas containing chlorine (Cl₂) gas and oxygen (O₂) gas with using the resist pattern as an etching mask to form a pattern of the absorption film. The dry etching was performed by an inductively coupled plasma (ICP) method under the conditions: Cl₂ flow rate: 185 SCCM, O₂ flow rate: 55 SCCM, He flow rate: 9.25 SCCM, pressure: 6 mTorr (0.8 Pa), ICP power: 400W, RIE voltage: 700V, and over-etching: 227 seconds (in Example 1) and 454 seconds (in Example 2). At this stage, a cross-section at the portion where the absorption film was etched was observed by a transmission electron microscope (TEM). As a result, each of the etching prevention films remained at a thickness of 2 nm without loss.

Next, the etching prevention film at the portion where the etching prevention film was exposed by removing the absorption film was removed while removing the resist pattern by sulfuric acid-hydrogen peroxide mixture (SPM) to obtain the reflective mask. A cross-section at the portion where the absorption film was etched was observed by a transmission electron microscope (TEM). As a result, each of the absorption films remained at a thickness of 3 nm without damage. In addition, a favorable pattern of the absorption film was obtained.

### Comparative Example 1

A reflective mask blank was obtained in the same manner as in Example 1, except that the etching prevention film was not formed. Next, a resist pattern was formed in the same manner as in Example 1. Next, the absorption film was patterned by dry etching using a gas containing chlorine (Cl₂) gas and oxygen (O₂) gas with using the resist pattern as an etching mask in the same manner as in Example 1 to form a pattern of the absorption film. A cross-section at the portion where the absorption film was etched was observed by a transmission electron microscope (TEM). As a result, the protection film disappeared.

### Comparative Example 2

A reflective mask blank was obtained in the same manner as in Example 1, except that the etching prevention film was not formed. Next, a resist pattern was formed in the same manner as in Example 1. Next, the absorption film was patterned by dry etching using a gas containing chlorine (Cl₂) gas and oxygen (O₂) gas with using the resist pattern as an etching mask in the same manner as in Example 1, except the over-etching was 0 seconds, to form a pattern of the absorption film. A cross-section at the portion where the absorption film was etched was observed by a transmission electron microscope (TEM). As a result, it was confirmed that the absorption film remained at the portion where the absorption film should be removed on the protection film. In addition, a favorable pattern of the absorption film was not obtained since the line width dimensions were not controlled by over-etching.

## Claims

1. A reflective mask blank which is a material for a reflective mask used in EUV lithography utilizing EUV light as exposure light, comprising
a substrate,
a multilayer reflection film that is formed on one main surface of the substrate, and reflects the exposure light,
a protection film for protecting the multilayer reflection film that is formed on the multilayer reflection film, and
an absorption film that is formed on the protection film, and absorbs the exposure light, wherein
the protection film comprises ruthenium (Ru), and
the reflective mask blank further comprises an etching prevention film that comprises niobium (Nb) and is free of ruthenium (Ru) between the protection film and the absorption film.

2. The reflective mask blank of claim 1 wherein the etching prevention film consists of simple niobium (Nb), or a niobium (Nb) compound comprising niobium (Nb) and oxygen (O).

3. The reflective mask blank of claim 1 or 2 wherein the protection film consists of ruthenium (Ru).

4. The reflective mask blank of any one of claims 1 to 3 wherein the absorption film comprises chromium (Cr).

5. The reflective mask blank of any one of claims 1 to 4 wherein the absorption film comprises tantalum (Ta), and the reflective mask blank further comprises an etching mask film comprising chromium (Cr) on the absorption film.

6. A manufacturing method of a reflective mask, comprising the step of:
pattering the absorption film of the reflective mask blank of claim 4 by dry etching using a gas comprising chlorine (Cl) and oxygen (O).

7. A manufacturing method of a reflective mask, comprising the step of:
after patterning the absorption film of the reflective mask blank of claim 5, removing the etching mask film by dry etching using a gas comprising chlorine (Cl) and oxygen (O).

8. A manufacturing method of a reflective mask from the reflective mask blank of any one of claims 1 to 5, comprising the step of:
after forming a pattern of the absorption film, removing the etching prevention film at the portion exposed by removing the absorption film.

9. The manufacturing method of claim 8 wherein the etching prevention film at the portion exposed by removing the absorption film is removed by sulfuric acid-hydrogen peroxide mixture (SPM).
